# EUROPEAN PATENT APPLICATION

(11) **EP 4 614 572 A1**
(43) Date of publication of application: **10.09.2025**
(21) Application number: 23885376.6
(22) Date of filing: 08.09.2023
(51) Int. Cl.: H01L 27/04, H01L 21/3205, H01L 21/768, H01L 21/822, H01L 21/8234, H01L 23/522, H01L 27/00, H01L 27/06, H01L 27/088, H01L 27/146

(54) **ELECTRONIC DEVICE**

(30) Priority: 04.11.2022 JP 2022176835
(71) Applicant: Sony Semiconductor Solutions Corporation, Atsugi-shi, Kanagawa 243-0014 (JP)
(72) Inventor: TOZAWA, Katsunori, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/032860
(87) International publication number: WO 2024/095610

(57) **Abstract**

To improve noise resistance of a capacitive element formed in a through hole.

An electronic device includes: a substrate; a through hole penetrating the substrate; a capacitive electrode formed along a side wall of the through hole and used for a capacitive element; and an electromagnetic shield layer formed along the side wall of the through hole and formed around the capacitive electrode. The capacitive electrode may include: a first capacitive electrode used for the capacitive element; a second capacitive electrode used for the capacitive element; and a dielectric film provided between the first capacitive electrode and the second capacitive electrode. The electromagnetic shield layer may be connected to a ground potential. There may be included a wiring layer formed on the substrate.

## Description

### TECHNICAL FIELD

The present technology relates to an electronic device. Specifically, the present technology relates to an electronic device in which a capacitive element is provided in a through hole.

### BACKGROUND ART

A capacitive element may be formed on an electronic device, a circuit board, or the like in order to absorb a current change of a load and suppress fluctuation of a power supply voltage and generation of noise. For example, there has been proposed a semiconductor element in which a capacitive element is formed on an inner peripheral surface of a through hole provided in an insulator substrate (see, for example, Patent Document 1).

### CITATION LIST

### PATENT DOCUMENT

Patent Document 1: Japanese Patent Application Laid-Open No. 2020-141090

### SUMMARY OF THE INVENTION

### PROBLEMS TO BE SOLVED BY THE INVENTION

However, in the above-described conventional technology, the capacitive element formed in the through hole has been susceptible to noise through parasitic capacitance formed between the capacitive element and a through electrode formed in an adjacent through hole.

The present technology has been made in view of such a situation, and an object thereof is to improve noise resistance of a capacitive element formed in a through hole.

### SOLUTIONS TO PROBLEMS

The present technology has been made to solve the above-described problems, and a first aspect thereof is an electronic device including: a substrate; a through hole penetrating the substrate; a capacitive electrode formed along a side wall of the through hole and used for a capacitive element; and an electromagnetic shield layer formed along the side wall of the through hole and formed around the capacitive electrode. This brings about an effect that the capacitive element formed in the through hole is shielded.

Furthermore, in the first aspect, there may be further included a wiring layer formed on the substrate. This brings about an effect that the capacitive element formed in the through hole is connected to a circuit.

Furthermore, in the first aspect, the capacitive electrode may be formed from the side wall of the through hole to the wiring layer. This brings about an effect that the capacitive element is formed from the inside to the outside of the through hole.

Furthermore, in the first aspect, the electromagnetic shield layer may not be formed in the wiring layer. This brings about an effect that the electromagnetic shield layer is formed along the outer periphery of the capacitive electrode.

Furthermore, in the first aspect, the electromagnetic shield layer may be connected to a ground potential. This brings about an effect that shielding effect by the electromagnetic shield layer is stabilized.

Furthermore, in the first aspect, the capacitive electrode may include: a first capacitive electrode used for the capacitive element; a second capacitive electrode used for the capacitive element; and a dielectric film provided between the first capacitive electrode and the second capacitive electrode. This brings about an effect that the electromagnetic shield layer is formed separately from the capacitive element in the through hole.

Furthermore, in the first aspect, the electromagnetic shield layer may be used as a capacitive electrode facing the capacitive electrode in the capacitive element. This brings about an effect that the capacitive electrode of the capacitive element is also used as the electromagnetic shield layer.

Furthermore, in the first aspect, the through hole may include: a first through hole in which the capacitive electrode and the electromagnetic shield layer are formed; and a second through hole in which a through electrode is formed. This brings about an effect that a wiring line can be drawn out to the back surface side of the substrate.

Furthermore, in the first aspect, the capacitive electrode may be connected to the through electrode. This brings about an effect that the front surface side and the back surface side of the substrate are connected to each other via the through electrode and the capacitive element.

Furthermore, in the first aspect, the electromagnetic shield layer may be connected to the through electrode. This brings about an effect that the front surface side and the back surface side of the substrate are connected to each other via the through electrode and the electromagnetic shield layer.

Furthermore, in the first aspect, the capacitive electrode and the electromagnetic shield layer may be formed across a plurality of through holes. This brings about an effect that capacitance of the capacitive element is increased.

Furthermore, in the first aspect, the capacitive electrode may be connected to a wiring line formed in the wiring layer. This brings about an effect that the front surface side and the back surface side of the substrate are connected to each other via the capacitive element.

Furthermore, in the first aspect, the capacitive electrode may be connected to a guard ring formed in the wiring layer. This brings about an effect that the capacitive electrode is connected to the ground potential.

Furthermore, in the first aspect, there may be further included a back surface wiring layer formed on a back surface side of the substrate. This brings about an effect that a wiring line formed on the front surface side of the substrate can be drawn out from the back surface side of the substrate.

Furthermore, in the first aspect, the capacitive electrode may be connected externally via the back surface wiring layer. This brings about an effect that the capacitive element can be connected externally from the back surface side of the substrate.

Furthermore, in the first aspect, the electromagnetic shield layer may be connected externally via the back surface wiring layer. This brings about an effect that the electromagnetic shield layer can be connected externally from the back surface side of the substrate.

Furthermore, in the first aspect, a wiring line formed in the wiring layer and a back surface wiring line formed in the back surface wiring layer may be connected to each other via the capacitive element. This brings about an effect that the front surface side of the substrate and the back surface side of the substrate can be connected to each other via the capacitive element.

### BRIEF DESCRIPTION OF DRAWINGS

Fig. 1 is a diagram illustrating a configuration example of a semiconductor device according to a first embodiment.
Fig. 2 is a cross-sectional view illustrating an example of a method of manufacturing the semiconductor device according to the first embodiment.
Fig. 3 is a cross-sectional view illustrating the example of the method of manufacturing the semiconductor device according to the first embodiment.
Fig. 4 is a cross-sectional view illustrating the example of the method of manufacturing the semiconductor device according to the first embodiment.
Fig. 5 is a cross-sectional view illustrating the example of the method of manufacturing the semiconductor device according to the first embodiment.
Fig. 6 is a diagram illustrating a configuration example of a semiconductor device according to a second embodiment.
Fig. 7 is a diagram illustrating a configuration example of a semiconductor device according to a third embodiment.
Fig. 8 is a diagram illustrating a configuration example of a semiconductor device according to a fourth embodiment.
Fig. 9 is a diagram illustrating a configuration example of a semiconductor device according to a fifth embodiment.
Fig. 10 is a diagram illustrating a configuration example of a semiconductor device according to a sixth embodiment.
Fig. 11 is a diagram illustrating a configuration example of a semiconductor device according to a seventh embodiment.
Fig. 12 is a block diagram illustrating a schematic configuration example of a vehicle control system.
Fig. 13 is an explanatory diagram illustrating an example of installation positions of an imaging section.

### MODE FOR CARRYING OUT THE INVENTION

Modes for carrying out the present technology (hereinafter, referred to as embodiments) will be described below. The description will be given in the following order.
1. First Embodiment (Example in which Electromagnetic Shield Layer Is Provided in Through Hole in which Capacitive Element Is Formed)
2. Second Embodiment (Example of Providing Electromagnetic Shield Layer across Plurality of Through holes in which Capacitive Elements Are Formed)
3. Third Embodiment (Example in which One Capacitive Electrode of Capacitive Element Formed in Through Hole Is Used as Electromagnetic Shield Layer)
4. Fourth Embodiment (Example in which Electromagnetic Shield Layer Formed Using One Capacitive Electrode of Capacitive Element Formed in Through Hole Is Connected to Through Electrode)
5. Fifth Embodiment (Example in which Capacitive Electrode of Capacitive Element Shielded by Electromagnetic Shield Layer Formed in Through Hole Is Connected to Circuit Wiring Line)
6. Sixth Embodiment (Example in which Capacitive Electrode of Capacitive Element Shielded by Electromagnetic Shield Layer Formed in Through Hole Is Connected to Guard Ring)
7. Seventh Embodiment (Example in which Sensor Chip Is Stacked on Semiconductor Device Provided with Through Hole in which Capacitive Element Shielded by Electromagnetic Shield Layer Is Formed)
8. Application Example to Mobile Body

In the following description, a semiconductor device is taken as an example of an electronic device, the semiconductor device being provided with a through hole in which a capacitive element shielded by an electromagnetic shield layer is formed; however, the through hole in which the capacitive element shielded by the electromagnetic shield layer is formed may be applied to a circuit board. Furthermore, the through hole in which the capacitive element shielded by the electromagnetic shield layer is formed may be applied to a semiconductor package, or the through hole in which the capacitive element shielded by the electromagnetic shield layer is formed may be applied to a semiconductor module.

### <1. First Embodiment>

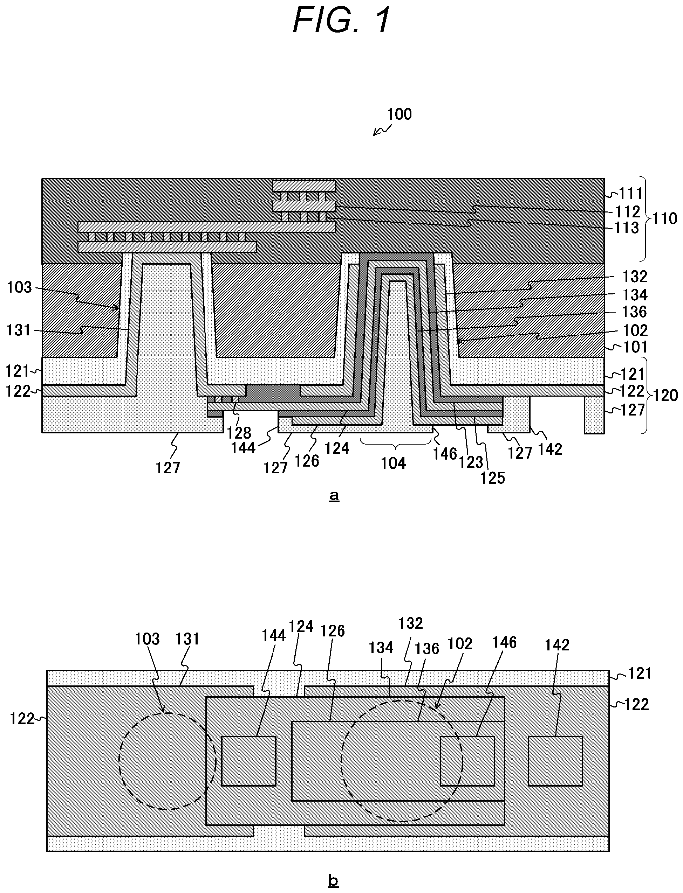

Fig. 1 is a diagram illustrating a configuration example of a semiconductor device according to a first embodiment. Note that a in the figure is a cross-sectional view illustrating a schematic configuration example of a semiconductor device 100, and b in the figure is a plan view illustrating a schematic configuration example of the semiconductor device 100. In b in the figure, a diagram is illustrated seen from a side of a back surface wiring layer 120 in a state where a protective film 127 is removed. Furthermore, in the drawings used in the following description, a scale, a shape, and the like may be different from those of an actual structure in order to facilitate understanding of each configuration.

In the figure, the semiconductor device 100 includes a semiconductor substrate 101, a wiring layer 110, and the back surface wiring layer 120. In the semiconductor device 100, a semiconductor element is formed. In the semiconductor device 100, a semiconductor memory may be formed such as a static random access memory (SRAM) or a dynamic random access memory (DRAM). Furthermore, in the semiconductor device 100, a processor may be formed such as a central processing unit (CPU) or a graphics processing unit (GPU). Furthermore, in the semiconductor device 100, a hardware circuit may be formed such as a field-programmable gate array (FPGA) or an application specific integrated circuit (ASIC). In the semiconductor device 100, a signal processing circuit may be formed, a data processing circuit may be formed, an interface circuit may be formed, or an optical element may be formed.

In the semiconductor substrate 101, semiconductor elements can be formed such as transistors and diodes. The semiconductor elements may be integrated together. Furthermore, in the semiconductor substrate 101, through holes 102 and 103 are formed. The through holes 102 and 103 may be disposed adjacent to each other. In the through hole 103, a through electrode 131 is formed. In the through hole 102, a capacitive element 104 and an electromagnetic shield layer 132 are formed. The electromagnetic shield layer 132 can be disposed in the through hole 102 so as to surround the periphery of the capacitive element 104. The electromagnetic shield layer 132 may be connected to a ground potential. The capacitive element 104 is provided with capacitive electrodes 134 and 136. At this time, in the through hole 102, the electromagnetic shield layer 132 and the capacitive electrode 134 can be disposed to face each other, and the capacitive electrodes 134 and 136 can be disposed to face each other. The capacitive element 104 may be formed from the inside of the through hole 102 to the back surface side of the semiconductor substrate 101. On the back surface side of the semiconductor substrate 101, the capacitive element 104 may be formed around the through hole 102. As a material of the semiconductor substrate 101, a semiconductor can be used such as Si, SiC, GaN, GaAs, or InGaAsP.

On the semiconductor substrate 101, the wiring layer 110 is formed. In the wiring layer 110, a wiring line 112 provided in the insulating layer 111 is formed. The wiring line 112 may be multilayer wiring lines. At this time, the wiring lines 112 may be connected to each other between layers via a via 113.

On the back surface side of the semiconductor substrate 101, the back surface wiring layer 120 is formed. The back surface wiring layer 120 includes an insulating layer 121, back surface wiring lines 122, 124, and 126, dielectric layers 123 and 125, and a protective film 127. The insulating layer 121 is formed on the back surface of the semiconductor substrate 101 so as to cover the inner peripheral surfaces of the through holes 102 and 103. On the insulating layer 121, the back surface wiring line 122, the dielectric layer 123, the back surface wiring line 124, the dielectric layer 125, and the back surface wiring line 126 are sequentially formed. At this time, the back surface wiring lines 122, 124, and 126 can have a three-layer wiring structure.

Here, the back surface wiring line 122 is extended on the insulating layer 121 in the through hole 103 and connected to the through electrode 131. The back surface wiring line 122 and the through electrode 131 may be continuous with each other. At this time, the back surface wiring line 122 and the through electrode 131 may be integrally deposited together. The through electrode 131 may enter the wiring layer 110 and be connected to the wiring line 112.

Furthermore, the back surface wiring line 122 is extended on the insulating layer 121 in the through hole 102 and connected to the electromagnetic shield layer 132. The back surface wiring line 122 and the electromagnetic shield layer 132 may be continuous with each other. At this time, the back surface wiring line 122 and the electromagnetic shield layer 132 may be integrally deposited together. The back surface wiring line 122, the through electrode 131, and the electromagnetic shield layer 132 may be formed in the same wiring layer. The back surface wiring line 122 connected to the through electrode 131 and the back surface wiring line 122 connected to the electromagnetic shield layer 132 can be separated from each other. Furthermore, the electromagnetic shield layer 132 may not be formed in the wiring layer 110. At this time, at an end of the through hole 102, the electromagnetic shield layer 132 may be removed.

Furthermore, the dielectric layer 123 is extended on the electromagnetic shield layer 132 in the through hole 102. At this time, the dielectric layer 123 can be disposed between the electromagnetic shield layer 132 and the capacitive electrode 134. The dielectric layer 123 may not be formed on the through electrode 131 in the through hole 103.

Furthermore, the back surface wiring line 124 is extended on the dielectric layer 123 in the through hole 102 and connected to the capacitive electrode 134. The back surface wiring line 124 and the capacitive electrode 134 may be continuous with each other. At this time, the back surface wiring line 124 and the capacitive electrode 134 may be integrally deposited together. The back surface wiring line 124 and the capacitive electrode 134 may be formed in the same wiring layer. Furthermore, the back surface wiring line 124 is extended on the back surface wiring line 122 connected to the through electrode 131. Then, the back surface wiring line 124 can be connected via a via 128 to the back surface wiring line 122 connected to the through electrode 131.

Furthermore, the dielectric layer 125 is extended on the capacitive electrode 134 in the through hole 102. At this time, the dielectric layer 125 can be disposed between the capacitive electrodes 134 and 136. The dielectric layer 125 may not be formed on the through electrode 131 in the through hole 103.

Furthermore, the back surface wiring line 126 is extended on the dielectric layer 125 in the through hole 102 and connected to the capacitive electrode 136. The back surface wiring line 126 and the capacitive electrode 136 may be continuous with each other. At this time, the back surface wiring line 126 and the capacitive electrode 136 may be integrally deposited together. The back surface wiring line 126 and the capacitive electrode 136 may be formed in the same wiring layer.

At this time, in the through hole 102, the capacitive element 104 is formed along the side wall of the through hole 102, and outside the capacitive element 104, the electromagnetic shield layer 132 is formed along the side wall of the through hole 102. A shape of each of the capacitive electrodes 134 and 136 and the electromagnetic shield layer 132 in the through hole 102 may be, for example, a cylinder shape, a cup shape, a glass shape, or a bucket shape.

The protective film 127 is formed on the back surface side of the semiconductor substrate 101 so as to be embedded in the through holes 102 and 103. At this time, the protective film 127 can cover the back surface wiring lines 122, 124, and 126, the through electrode 131, the electromagnetic shield layer 132, and the capacitive electrodes 134 and 136. The protective film 127 may be a solder mask.

In the protective film 127, openings 142, 144, and 146 are formed. The openings 142, 144, and 146 can expose parts of the back surface wiring lines 122, 124, and 126, respectively. At this time, solder balls may be connected to the back surface wiring lines 122, 124, and 126 via the openings 142, 144, and 146, respectively, or bonding wires may be connected thereto. Here, by connecting the back surface wiring line 122 to the ground potential via the opening 142, it is possible to set the electromagnetic shield layer 132 to the ground potential.

As a material of the wiring line 112, the back surface wiring lines 122, 124, and 126, the through electrode 131, the capacitive electrodes 134 and 136, and the vias 113 and 128, it is possible to use, for example, Cu, Ti, Ta, Al, W, Ni, Ru, Co, TiN, TaN, or WN, and a stacked structure of a plurality of the materials may be used.

As a material of the dielectric layers 123 and 125, it is possible to use, for example, SiO₂, SiON, Si₃N₄, hafnium oxide (HfO₂), aluminum oxide (Al₂O₃), zirconium oxide (ZrO), tantalum oxide (Ta₂O₅), titanium oxide (TiO₂), lanthanum oxide (LaO₃), yttrium oxide (Y₂O₃), aluminum nitride (AlN), hafnium oxynitride (HfON), or aluminum oxynitride (AlON), and a stacked structure of a plurality of the materials may be used.

As a material of the insulating layers 111 and 121, it is possible to use, for example, an inorganic material such as SiO₂, SiON, SiOC, Si₃N₄, or SiCO, or an organic material having a skeleton of polyimide, acrylic, silicone, or an epoxy group, and a stacked structure of a plurality of the materials may be used.

As a material of the protective film 127, it is possible to use an organic material having a skeleton of polyimide, acrylic, silicone, or an epoxy group, or a material containing a filler such as SiO₂, Al₂O₃, AlN, or BN. The protective film 127 may be a chemical vapor deposition (CVD) film or a coating film.

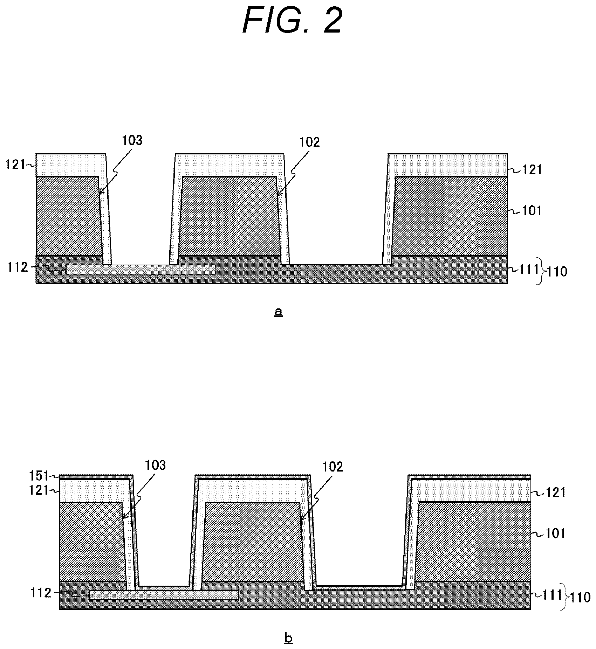

Figs. 2 to 5 are cross-sectional views illustrating an example of a method of manufacturing the semiconductor device according to the first embodiment.

In a in Fig. 2, the wiring layer 110 is formed on the semiconductor substrate 101. In the semiconductor substrate 101, a semiconductor element may be formed. Then, the semiconductor substrate 101 is etched from the back surface side through a resist pattern formed on the basis of lithography to form the through holes 102 and 103 of the semiconductor substrate 101. Moreover, the insulating layer 121 is formed on the back surface of the semiconductor substrate 101 so as to cover the side walls of the through holes 102 and 103 by a method such as CVD. Thereafter, the insulating layer 121 is etched back through the through holes 102 and 103 to remove the insulating layer 121 at the end of each of the through holes 102 and 103. Then, the insulating layer 111 is etched through the through hole 103 to expose a part of the wiring line 112.

Next, as illustrated in b in Fig. 2, a seed metal layer 151 is formed on the insulating layer 121 by a method such as sputtering or ion metal plasma (IMP). At this time, the seed metal layer 151 can also be formed on the insulating layer 111 exposed through the through hole 102 and the wiring line 112 exposed through the through hole 103.

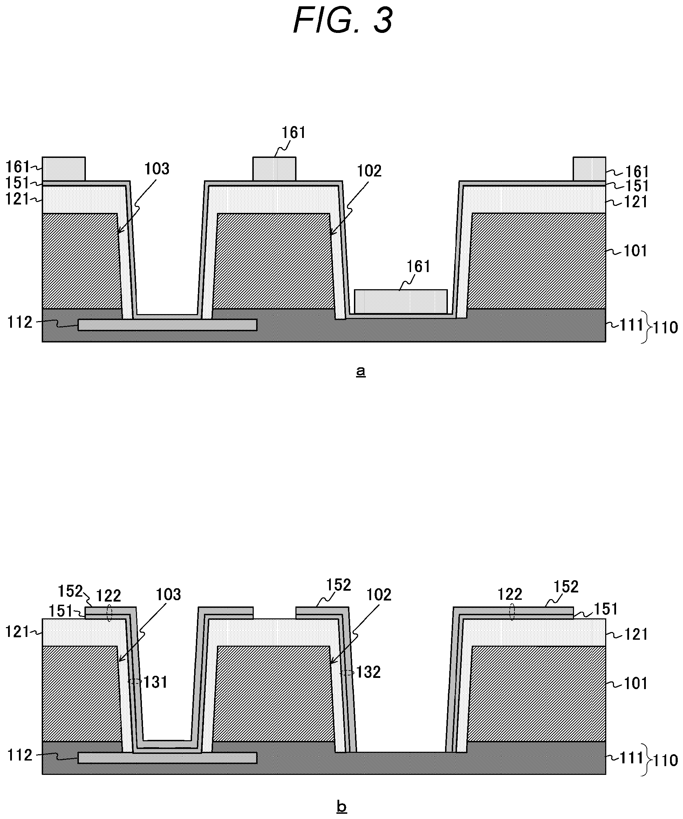

Next, as illustrated in a in Fig. 3, a resist pattern 161 is formed on the seed metal layer 151 on the basis of lithography. The resist pattern 161 can be provided in a region where the back surface wiring line 122, the through electrode 131, and the electromagnetic shield layer 132 are not formed. At this time, the resist pattern 161 can be formed not only on the seed metal layer 151 on the back surface side of the semiconductor substrate 101 but also on the seed metal layer 151 at the end of the through hole 102.

Next, as illustrated in b in Fig. 3, on the seed metal layer 151 exposed from the resist pattern 161, a plating layer 152 is selectively formed. Then, the resist pattern 161 is removed, and the seed metal layer 151 exposed from the plating layer 152 is selectively removed. At this time, a two-layer structure of the seed metal layer 151 and the plating layer 152 that are formed with the pattern can be used as the back surface wiring line 122, the through electrode 131, and the electromagnetic shield layer 132.

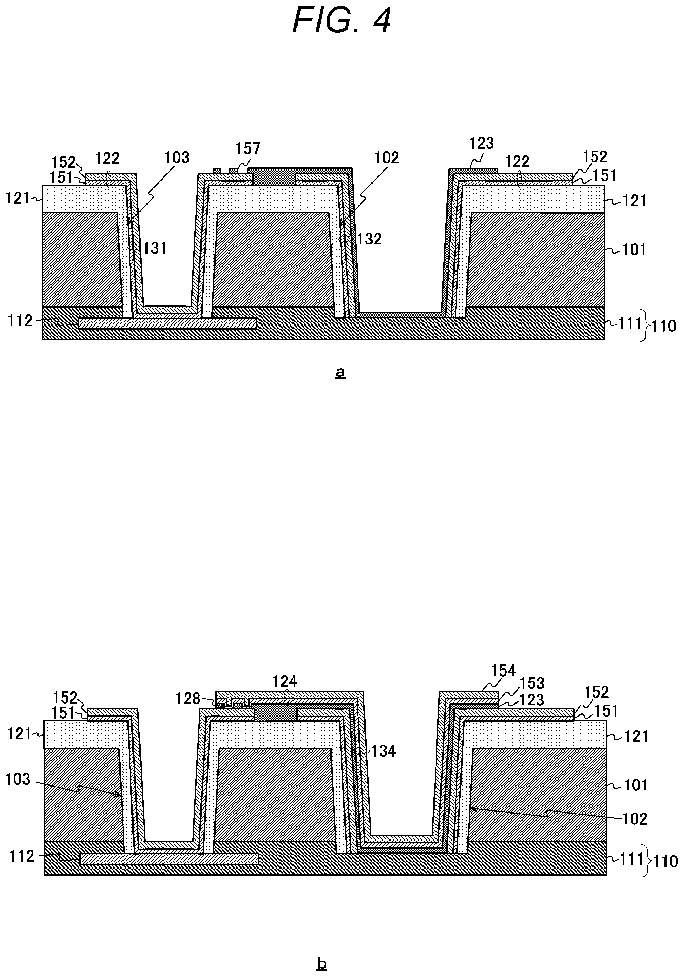

Next, as illustrated in a in Fig. 4, the dielectric layer 123 is formed on the plating layer 152 and the insulating layer 121 by a method such as CVD. Then, the dielectric layer 123 is etched through a resist pattern formed on the basis of lithography to remove the dielectric layer 123 in the through hole 103, and remove the dielectric layer 123 on the back surface side of the semiconductor substrate 101 around the through hole 102. At this time, in the dielectric layer 123, an opening 157 may be formed in which the via 128 is to be embedded.

Next, as illustrated in b in Fig. 4, a seed metal layer 153 and a plating layer 154 are selectively formed on the dielectric layer 123 by a method similar to that in the formation of the seed metal layer 151 and the plating layer 152. At this time, a two-layer structure of the seed metal layer 153 and plating layer 154 that are formed with the pattern can be used as the back surface wiring line 124, the capacitive electrode 134, and the via 128.

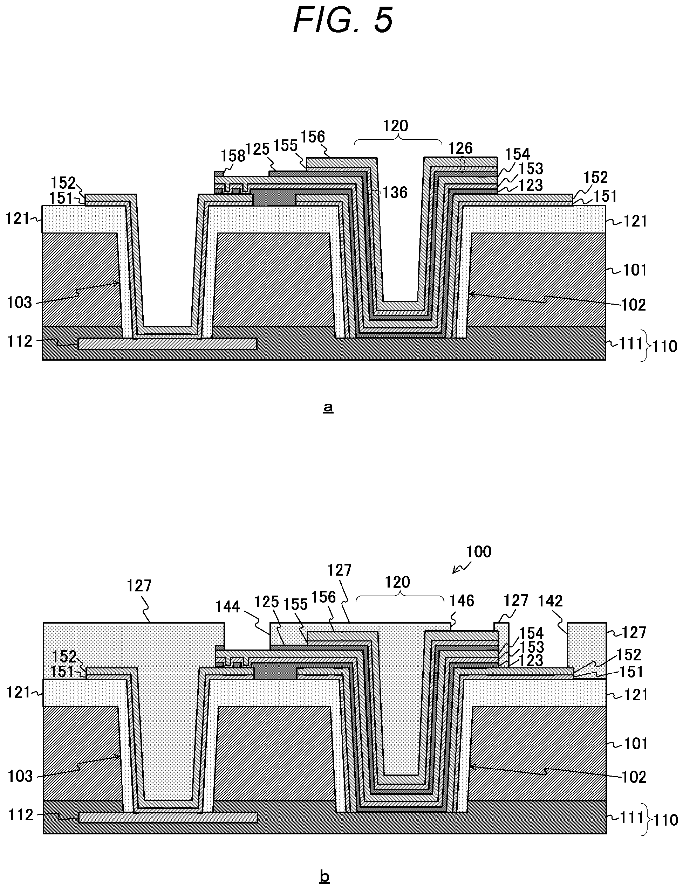

Next, as illustrated in a in Fig. 5, the dielectric layer 125, a seed metal layer 155, and a plating layer 156 are selectively formed on the plating layer 154 by a method similar to that in the formation of the dielectric layer 123, the seed metal layer 153, and the plating layer 154. At this time, a two-layer structure of the seed metal layer 155 and plating layer 156 that are formed with the pattern can be used as the back surface wiring line 126 and the capacitive electrode 136. As a result, the capacitive element 104 whose periphery is covered by the electromagnetic shield layer 132 is formed in the through hole 102. Note that, in the dielectric layer 125, an opening 158 may be formed for exposing the plating layer 154.

Next, as illustrated in b in Fig. 5, the protective film 127 is formed on the back surface side of the semiconductor substrate 101 so as to be embedded in the through holes 102 and 103. Then, the protective film 127 is etched through a resist pattern formed on the basis of lithography to form the openings 142, 144, and 146 in the protective film 127. Note that, in order to enable patterning of the protective film 127, the protective film 127 may include a photosensitive resin.

As described above, in the first embodiment described above, the electromagnetic shield layer 132 is provided in the through hole 102 in which the capacitive element 104 is formed. As a result, the capacitive element 104 can be made less susceptible to noise through parasitic capacitance formed between the capacitive element 104 and the through electrode 131 formed in the through hole 103. Therefore, it is possible to increase capacitance of the capacitive element 104 while suppressing an increase in a planar size of the capacitive element 104, and it is possible to improve noise resistance of the capacitive element 104 formed in the through hole 102.

### <2. Second Embodiment>

In the first embodiment described above, the capacitive element 104 whose periphery is covered with the electromagnetic shield layer 132 is formed in the through hole 102. In this second embodiment, a capacitive element whose periphery is covered by the electromagnetic shield layer 132 is formed across a plurality of the through holes 102.

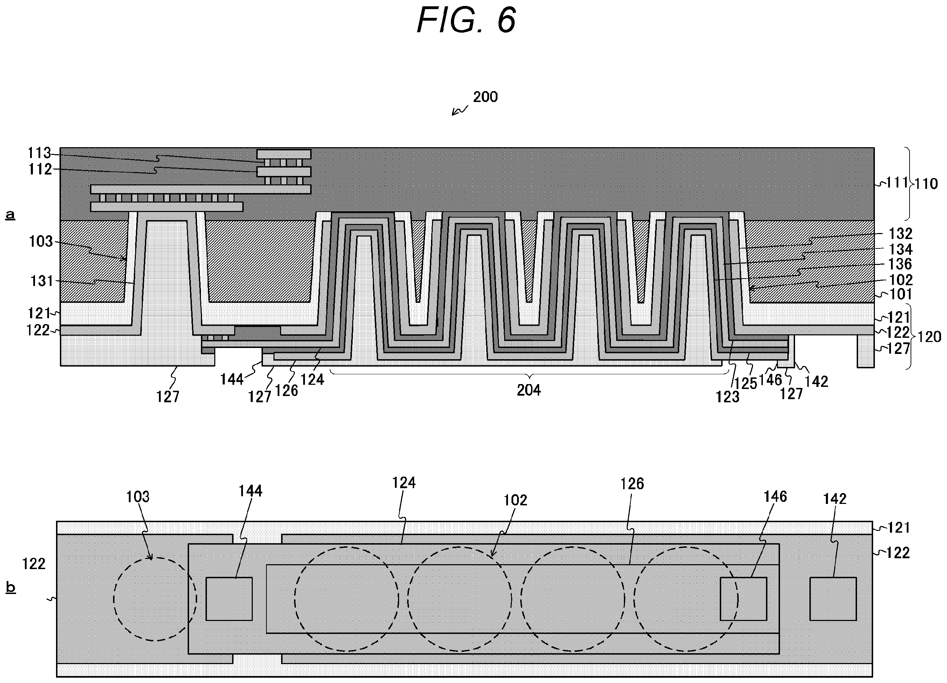

Fig. 6 is a diagram illustrating a configuration example of a semiconductor device according to the second embodiment. Note that a in the figure is a cross-sectional view illustrating a schematic configuration example of a semiconductor device 200, and b in the figure is a plan view illustrating a schematic configuration example of the semiconductor device 200.

In the figure, the semiconductor device 200 includes a capacitive element 204 instead of the capacitive element 104 of the first embodiment described above. Other than that, a configuration of the semiconductor device 200 of the second embodiment is similar to that of the semiconductor device 100 of the first embodiment described above.

In the semiconductor substrate 101, a plurality of the through holes 102 is formed. The plurality of through holes 102 may be disposed adjacent to each other. The plurality of through holes 102 may be disposed in one row or may be disposed in a plurality of rows. The capacitive element 204 and the electromagnetic shield layer 132 are formed in the through hole 102. The capacitive element 204 can be formed across the plurality of through holes 102. The electromagnetic shield layer 132 can be continuously disposed across the plurality of through holes 102 so as to surround the periphery of the capacitive element 204. The capacitive element 204 is provided with the capacitive electrodes 134 and 136. In the plurality of through holes 102, the electromagnetic shield layer 132 and the capacitive electrode 134 can be disposed to face each other, and the capacitive electrodes 134 and 136 can be disposed to face each other. At this time, the capacitive electrodes 134 and 136 each can be continuously disposed across the plurality of through holes 102.

The insulating layer 121 is formed on the back surface of the semiconductor substrate 101 so as to cover the inner peripheral surfaces of the plurality of through holes 102. The electromagnetic shield layer 132 is formed on the insulating layer 121 along the inner peripheral surfaces of the plurality of through holes 102 and is connected to the back surface wiring line 122. The dielectric layer 123 is formed on the electromagnetic shield layer 132 along the inner peripheral surfaces of the plurality of through holes 102. The capacitive electrode 134 is formed on the dielectric layer 123 along the inner peripheral surfaces of the plurality of through holes 102, and is connected to the back surface wiring line 124. The dielectric layer 125 is formed on the capacitive electrode 134 along the inner peripheral surfaces of the plurality of through holes 102. The capacitive electrode 136 is formed on the dielectric layer 125 along the inner peripheral surfaces of the plurality of through holes 102, and is connected to the back surface wiring line 126. The protective film 127 is formed on the back surface side of the semiconductor substrate 101 so as to be embedded in the through holes 102 and a plurality of the through holes 103. At this time, the protective film 127 can cover the capacitive element 204 formed across the plurality of through holes 102.

As described above, in the second embodiment described above, the capacitive element 204 whose periphery is covered by the electromagnetic shield layer 132 is formed across the plurality of through holes 102. As a result, it is possible to increase capacitance of the capacitive element 204 while suppressing an increase in a planar size of the capacitive element 204.

### <3. Third Embodiment>

In the first embodiment described above, the electromagnetic shield layer 132 is formed in the through hole 102 so as to cover the periphery of the capacitive element 104 provided with the capacitive electrodes 134 and 136. In this third embodiment, the capacitive electrodes 136, which is one of capacitive electrodes used for a capacitive element formed in the through hole 102, is used as the electromagnetic shield layer 132.

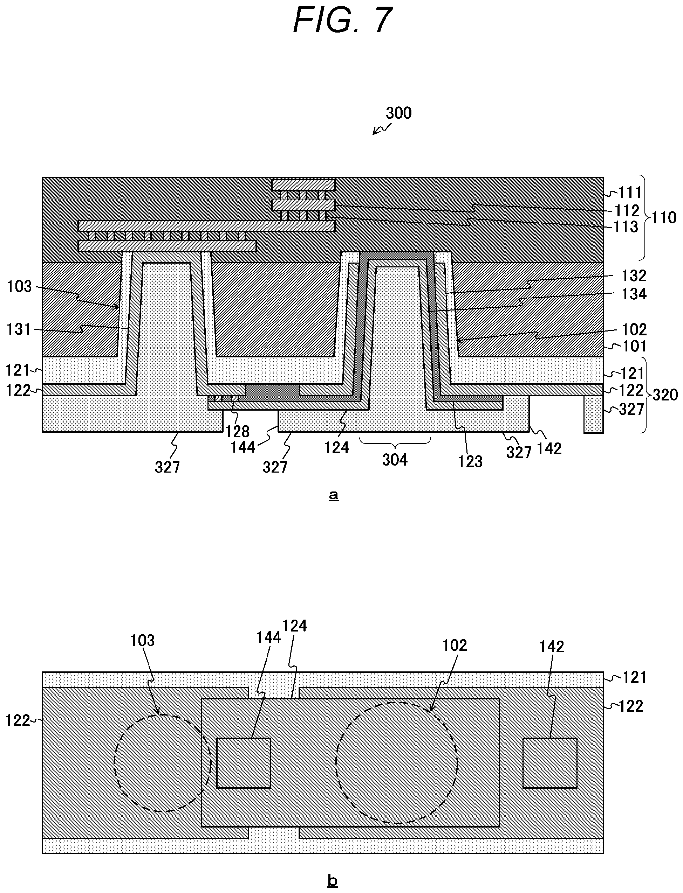

Fig. 7 is a diagram illustrating a configuration example of a semiconductor device according to the third embodiment. Note that a in the figure is a cross-sectional view illustrating a schematic configuration example of a semiconductor device 300, and b in the figure is a plan view illustrating a schematic configuration example of the semiconductor device 300.

In the figure, the semiconductor device 300 includes a capacitive element 304 and a back surface wiring layer 320 instead of the capacitive element 104 and the back surface wiring layer 120 of the first embodiment described above. Other than that, a configuration of the semiconductor device 300 of the third embodiment is similar to that of the semiconductor device 100 of the first embodiment described above.

The capacitive element 304 is formed in the through hole 102. The capacitive electrode 136 and the dielectric layer 125 of the first embodiment described above are removed from the capacitive element 304. At this time, the capacitive element 304 includes the electromagnetic shield layer 132 and the capacitive electrode 134 disposed to face each other with the dielectric layer 123 interposed therebetween. Here, a diameter in the through hole 102 of the capacitive element 304 including the electromagnetic shield layer 132 and the capacitive electrode 134 can be made larger than a diameter in the through hole 102 of the capacitive element 104 including the capacitive electrodes 134 and 136.

The back surface wiring line 126 and the dielectric layer 125 of the first embodiment described above are removed from the back surface wiring layer 320. Furthermore, the back surface wiring layer 320 includes a protective film 327 instead of the protective film 127 of the first embodiment described above. Other than that, a configuration of the back surface wiring layer 320 is similar to that of the back surface wiring layer 120 of the first embodiment described above.

The protective film 327 is formed on the back surface side of the semiconductor substrate 101 so as to be embedded in the through holes 102 and 103. The protective film 327 can cover the wiring lines 122 and 124, the through electrode 131, the electromagnetic shield layer 132, and the capacitive electrode 134. At this time, the opening 146 of the first embodiment described above is removed from the protective film 127.

As described above, in the third embodiment described above, the electromagnetic shield layer 132 is used as one capacitive electrode used for the capacitive element 304 formed in the through hole 102. As a result, capacitance in the through hole 102 of the capacitive element 304 can be increased as compared with capacitance in the through hole 102 of the capacitive element 104 including the capacitive electrodes 134 and 136. Furthermore, in the capacitive element 304, the formation of the capacitive electrode 136 and the dielectric layer 125 can be made unnecessary, and a manufacturing process can be simplified as compared with a method of forming the capacitive element 104 including the capacitive electrodes 134 and 136.

### <4. Fourth Embodiment>

In the third embodiment described above, the electromagnetic shield layer 132 is used as one capacitive electrode used for the capacitive element 304 formed in the through hole 102. In this fourth embodiment, the electromagnetic shield layer 132 using one capacitive electrode of a capacitive element formed in the through hole 102 is connected to the through electrode 131.

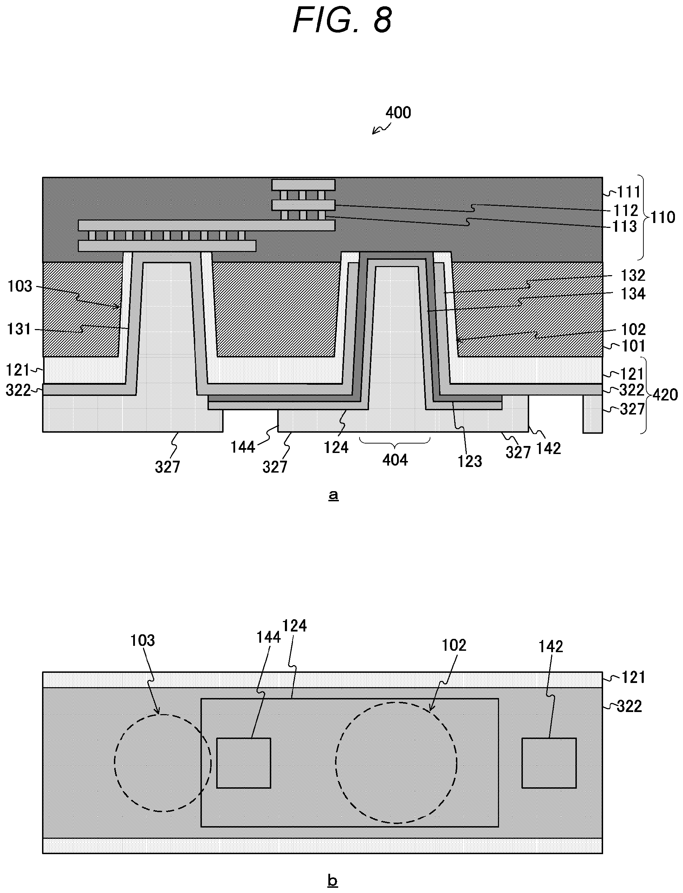

Fig. 8 is a diagram illustrating a configuration example of a semiconductor device according to the fourth embodiment. Note that a in the figure is a cross-sectional view illustrating a schematic configuration example of a semiconductor device 400, and b in the figure is a plan view illustrating a schematic configuration example of the semiconductor device 400.

In the figure, the semiconductor device 400 includes a capacitive element 404 and a back surface wiring layer 420 instead of the capacitive element 304 and the back surface wiring layer 320 of the third embodiment described above. Other than that, a configuration of the semiconductor device 400 of the fourth embodiment is similar to that of the semiconductor device 300 of the third embodiment described above.

The via 128 of the third embodiment described above is removed from the back surface wiring layer 420. Furthermore, the back surface wiring layer 420 includes a back surface wiring line 322 instead of the back surface wiring line 122 of the third embodiment described above. Other than that, a configuration of the back surface wiring layer 420 is similar to that of the back surface wiring layer 320 of the third embodiment described above.

The back surface wiring line 322 is extended on the insulating layer 121 in the through hole 102 and connected to the electromagnetic shield layer 132. Furthermore, the back surface wiring line 322 is extended on the insulating layer 121 in the through hole 103 and connected to the through electrode 131. The back surface wiring line 322, the electromagnetic shield layer 132, and the through electrode 131 may be continuous with each other. At this time, the back surface wiring line 322, the electromagnetic shield layer 132, and the through electrode 131 may be integrally deposited together. The back surface wiring line 322, the through electrode 131, and the electromagnetic shield layer 132 may be formed in the same wiring layer.

The capacitive element 404 is formed in the through hole 102. The capacitive element 404 includes the electromagnetic shield layer 132 and the capacitive electrode 134 disposed to face each other with the dielectric layer 123 interposed therebetween. The electromagnetic shield layer 132 is connected to the through electrode 131 via the back surface wiring line 322.

As described above, in the fourth embodiment described above, the electromagnetic shield layer 132 using one capacitive electrode of the capacitive element 404 formed in the through hole 102 is connected to the through electrode 131. As a result, the ground potential of the wiring layer 110 can be set on the basis of the ground potential set in the electromagnetic shield layer 132, and an external terminal used for setting the ground potential of the wiring layer 110 can be omitted.

### <5. Fifth Embodiment>

In the first embodiment described above, the capacitive element 104 whose periphery is covered with the electromagnetic shield layer 132 is formed in the through hole 102. In this fifth embodiment, the capacitive electrode 134 of the capacitive element 104 shielded by the electromagnetic shield layer 132 formed in the through hole 102 is connected to a circuit wiring line.

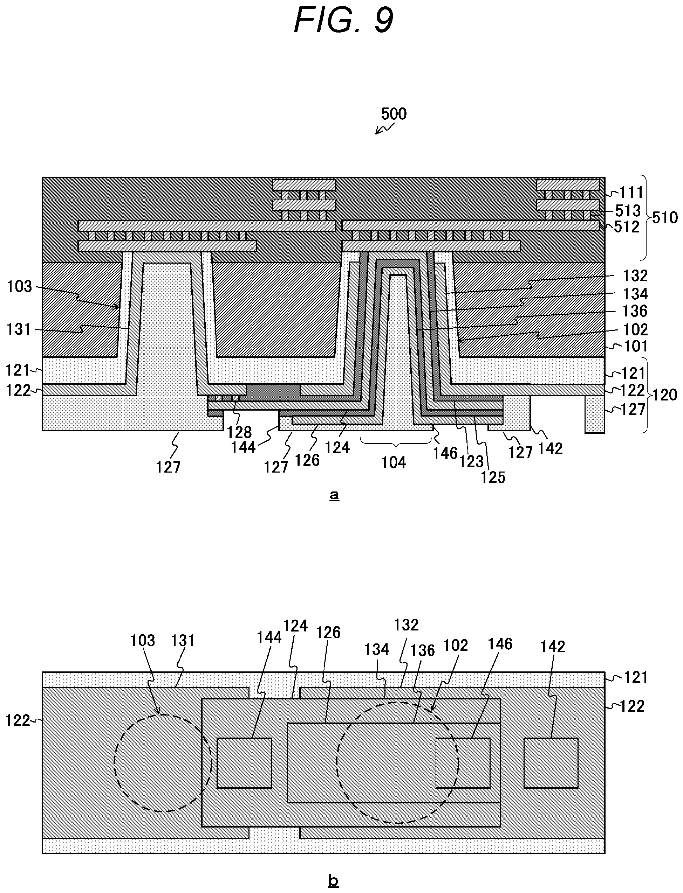

Fig. 9 is a diagram illustrating a configuration example of a semiconductor device according to the fifth embodiment. Note that a in the figure is a cross-sectional view illustrating a schematic configuration example of a semiconductor device 500, and b in the figure is a plan view illustrating a schematic configuration example of the semiconductor device 500.

In the figure, the semiconductor device 500 includes a wiring layer 510 instead of the wiring layer 110 of the first embodiment described above. Other than that, a configuration of the semiconductor device 500 of the fifth embodiment is similar to that of the semiconductor device 100 of the first embodiment described above.

The wiring layer 510 is formed on the semiconductor substrate 101. In the wiring layer 510, a wiring line 512 provided in the insulating layer 111 is formed. The wiring line 512 may be multilayer wiring lines. At this time, the wiring lines 512 may be connected to each other between layers via a via 513. The wiring line 512 can include the circuit wiring line. At this time, the wiring line 512 can be connected to a semiconductor element formed on the semiconductor substrate 101.

The capacitive element 104 is provided with capacitive electrodes 134 and 136. In the through hole 102, the capacitive electrode 134 is provided outside the capacitive electrode 136. At this time, the capacitive electrode 134 penetrates the dielectric layer 123 and is connected to the wiring line 512 including the circuit wiring line.

As described above, in the fifth embodiment described above, the capacitive electrode 134 of the capacitive element 104 shielded by the electromagnetic shield layer 132 formed in the through hole 102 is connected to the wiring line 512. As a result, the wiring layer 510 and the back surface wiring layer 120 can be connected to each other via the capacitive element 104 shielded by the electromagnetic shield layer 132. Therefore, it is possible to transmit a signal from the back surface wiring layer 120 to the wiring layer 510 without using the through electrode 131, and it is possible to reduce noise of the signal transmitted from the back surface wiring layer 120 to the wiring layer 510.

### <6. Sixth Embodiment>

In the fifth embodiment described above, the capacitive electrode 134 of the capacitive element 104 shielded by the electromagnetic shield layer 132 formed in the through hole 102 is connected to the circuit wiring line. In this sixth embodiment, the capacitive electrode 134 of the capacitive element 104 shielded by the electromagnetic shield layer 132 formed in the through hole 102 is connected to a guard ring.

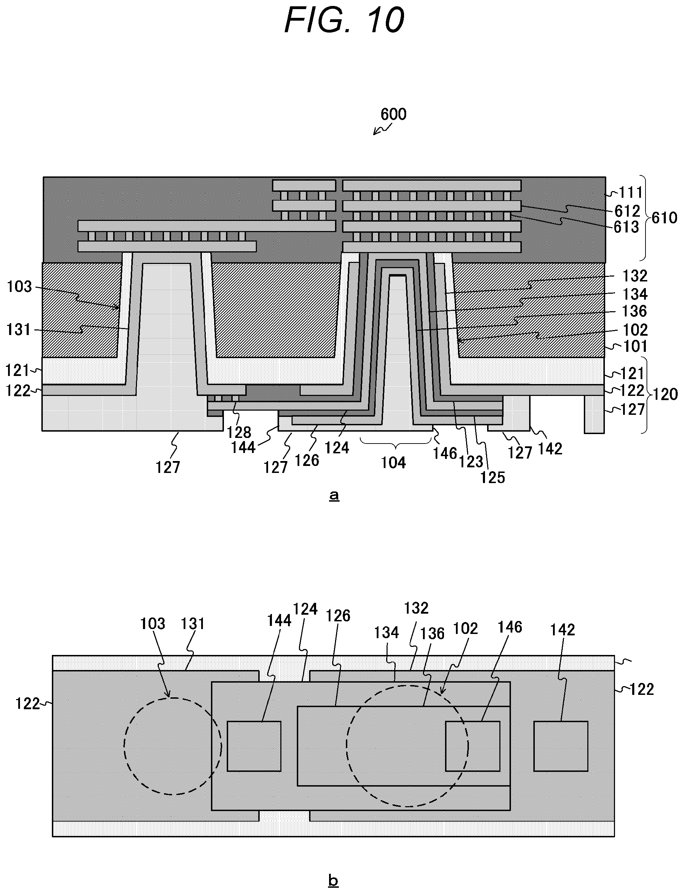

Fig. 10 is a diagram illustrating a configuration example of a semiconductor device according to the sixth embodiment. Note that a in the figure is a cross-sectional view illustrating a schematic configuration example of a semiconductor device 600, and b in the figure is a plan view illustrating a schematic configuration example of the semiconductor device 600.

In the figure, the semiconductor device 600 includes a wiring layer 610 instead of the wiring layer 510 of the fifth embodiment described above. Other than that, a configuration of the semiconductor device 600 of the sixth embodiment is similar to that of the semiconductor device 500 of the fifth embodiment described above.

The wiring layer 610 is formed on the semiconductor substrate 101. In the wiring layer 610, a wiring line 612 provided in the insulating layer 111 is formed. The wiring line 612 may be multilayer wiring lines. At this time, the wiring lines 612 may be connected to each other between layers via a via 613. The wiring line 612 can include the guard ring. The guard ring may be connected to the ground potential.

The capacitive element 104 is provided with capacitive electrodes 134 and 136. At this time, the capacitive electrode 134 penetrates the dielectric layer 123 and is connected to the wiring line 612 including the guard ring.

As described above, in the sixth embodiment described above, the capacitive electrode 134 of the capacitive element 104 shielded by the electromagnetic shield layer 132 formed in the through hole 102 is connected to the guard ring. As a result, the electromagnetic shield layer 132 can be set to the ground potential on the basis of the ground potential set on the guard ring.

### <7. Seventh Embodiment>

In the first embodiment described above, the capacitive element 104 whose periphery is covered with the electromagnetic shield layer 132 is formed in the through hole 102. In this seventh embodiment, a sensor chip is stacked on the semiconductor device 100 provided with the through hole 102 in which the capacitive element 104 shielded by the electromagnetic shield layer 132 is formed.

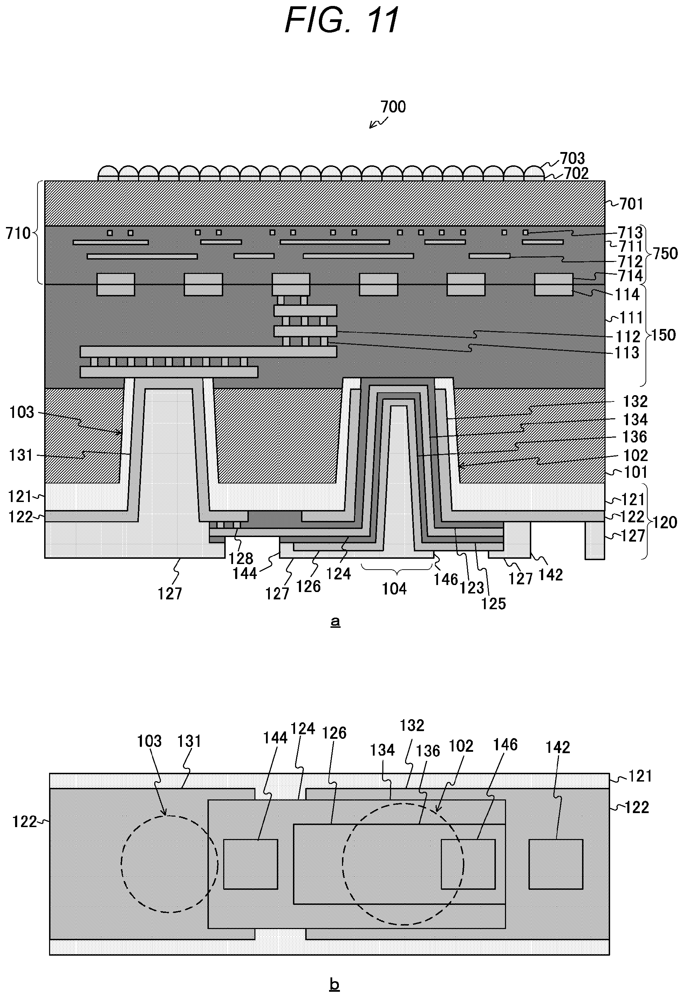

Fig. 11 is a diagram illustrating a configuration example of a semiconductor device according to the seventh embodiment. Note that a in the figure is a cross-sectional view illustrating a schematic configuration example of a semiconductor device 700, and b in the figure is a plan view illustrating a schematic configuration example of the semiconductor device 700.

In the figure, the semiconductor device 700 includes a wiring layer 150 instead of the wiring layer 110 of the first embodiment described above. Furthermore, in the semiconductor device 700, a sensor chip 710 is added to the semiconductor device 100 of the first embodiment described above. Other than that, a configuration of the semiconductor device 700 of the seventh embodiment is similar to that of the semiconductor device 100 of the first embodiment described above.

The wiring layer 150 is formed on the semiconductor substrate 101. In the wiring layer 150, the wiring line 112 and a pad electrode 114 are formed, which are provided in the insulating layer 111. At this time, the wiring line 112 and the pad electrode 114 may be connected to each other between layers via the via 113. The pad electrode 114 can be used for direct bonding of the wiring layer 150.

The sensor chip 710 is stacked on the wiring layer 110. In the sensor chip 710, a sensor element is formed. The sensor element may be a solid-state imaging element such as a charged coupled device (CCD) or a complementary metal-oxide semiconductor (CMOS), or may be a light receiving element such as a photo diode (PD). Light received by the solid-state imaging element or the light receiving element may be visible light, near infrared light (NIR), short wavelength infrared light (SWIR), ultraviolet light, X-ray, or the like. The sensor chip 710 may include a light emitting element such as a laser diode (LD), a light emitting diode (LED), or a vertical cavity surface emitting laser (VCSEL). Note that, in the following description, an example will be described in which a back-illuminated solid-state imaging element is formed on the sensor chip 710.

The sensor chip 710 includes a semiconductor layer 701 and a wiring layer 750. The semiconductor layer 701 is provided with an imaging region and a non-imaging region. In the imaging region, pixels and pixel transistors are disposed that are arranged in a matrix along the row direction and the column direction. In the non-imaging region, a peripheral circuit is provided that drives the pixel transistors and outputs signals read from the pixels.

On the back surface side of the semiconductor layer 701, an on-chip lens 703 is formed for each pixel with a color filter 702 interposed therebetween. As a material of the color filter 702 and the on-chip lens 703, for example, a transparent resin can be used such as acrylic or polycarbonate. The color filter 702 may include a pigment. For example, the color filter 702 may form a Bayer array or a quad-Bayer array. The color filter 702 may include an RGB filter, a complementary color filter, or a white filter.

On the semiconductor layer 701 on which the sensor element is formed, a gate electrode 713 is formed, and the wiring layer 750 is formed so as to cover the gate electrode 713. In the wiring layer 750, a wiring line 712 and a pad electrode 714 are formed, which are provided in the insulating layer 711. The wiring line 712 may be multilayer wiring lines. The pad electrode 714 can be used for direct bonding of the sensor chip 710.

The sensor chip 710 can be electrically connected to the wiring layer 150 via the wiring layer 750. In order to electrically connect the sensor chip 710 to the wiring layer 150 via the wiring layer 750, the wiring layer 750 may be directly bonded to the wiring layer 150. In the direct bonding, hybrid bonding including Cu-Cu bonding may be used.

In the hybrid bonding, the pad electrode 114 is exposed on the surface of the wiring layer 150, the pad electrode 714 is exposed on the surface of the wiring layer 750, and the pad electrodes 114 and 714 are formed at positions facing each other. At this time, Cu can be used as a material of each of the pad electrodes 114 and 714. As a material of the insulating layers 111 and 711, for example, SiO₂, SiN, or SiCN can be used. Furthermore, the pad electrodes 114 and 714 are recessed by about several tens nm from the surfaces of the wiring layers 150 and 750, respectively. At this time, a planar size of each of the pad electrodes 114 and 714 can be set within a range of 0.1 µm to 10 µm. Then, after surface processing of the insulating layers 111 and 711 is performed, the insulating layers 111 and 711 are brought into facing contact with each other, so that the insulating layers 111 and 711 are connected to each other. At this time, between the pad electrodes 114 and 7141, a slight gap is formed. Then, heat processing is performed in a state where the insulating layers 111 and 711 are pressure-bonded to each other, whereby the pad electrodes 114 and 714 expand, the pad electrodes 114 and 714 come into contact with each other, and mutual diffusion of Cu occurs, so that bonding is formed between the pad electrodes 114 and 714.

In the hybrid bonding, the planar size of each of the pad electrodes 114 and 714 can be set within the range of 0.1 µm to 10 µm. Therefore, as compared with a method of bonding the sensor chip 710 to the wiring layer 150 with solder interposed therebetween, a pitch of bonding electrodes can be narrowed, and it is possible to cope with an increase in input/output of the sensor chip 710 while suppressing an increase in a chip area of the sensor chip 710.

As described above, in the seventh embodiment described above, the sensor chip 710 is stacked on the semiconductor device 100 provided with the through hole 102 in which the capacitive element 104 shielded by the electromagnetic shield layer 132 is formed. As a result, it is possible to improve noise resistance of a signal transmission interface circuit used for the solid-state imaging element formed in the sensor chip 710, and to improve performance of signal noise control.

### <15. Application Example to Mobile Body>

The technology according to the present disclosure (the present technology) can be applied to various products. For example, the technology according to the present disclosure may be implemented as a device to be mounted on a mobile body of any kind, such as an automobile, an electric automobile, a hybrid electric automobile, a motorcycle, a bicycle, a personal mobility, an airplane, a drone, a ship, or a robot.

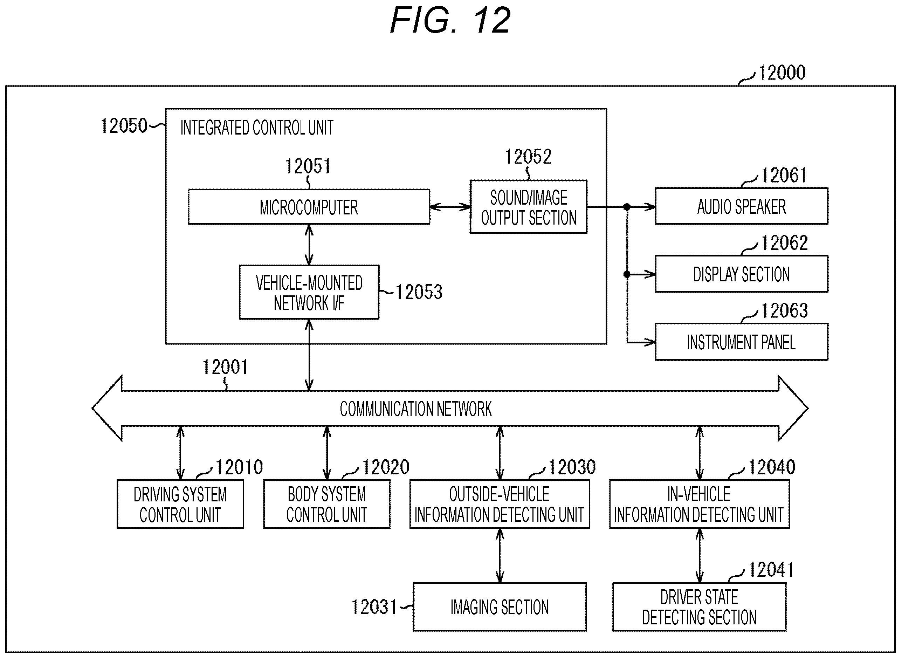

Fig. 12 is a block diagram illustrating a schematic configuration example of a vehicle control system as an example of a mobile body control system to which the technology according to the present disclosure can be applied.

The vehicle control system 12000 includes a plurality of electronic control units connected to each other via a communication network 12001. In the example illustrated in Fig. 12, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and a vehicle-mounted network interface (I/F) 12053 are illustrated as functional components of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. Furthermore, the light received by the imaging section 12031 may be visible light, or may be invisible light such as infrared rays.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 can output a control command to the body system control unit 12020, on the basis of the information about the outside of the vehicle obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example in Fig. 12, as the output device, an audio speaker 12061, a display section 12062, and an instrument panel 12063 are illustrated. The display section 12062 may, for example, include at least one of an on-board display and a head-up display.

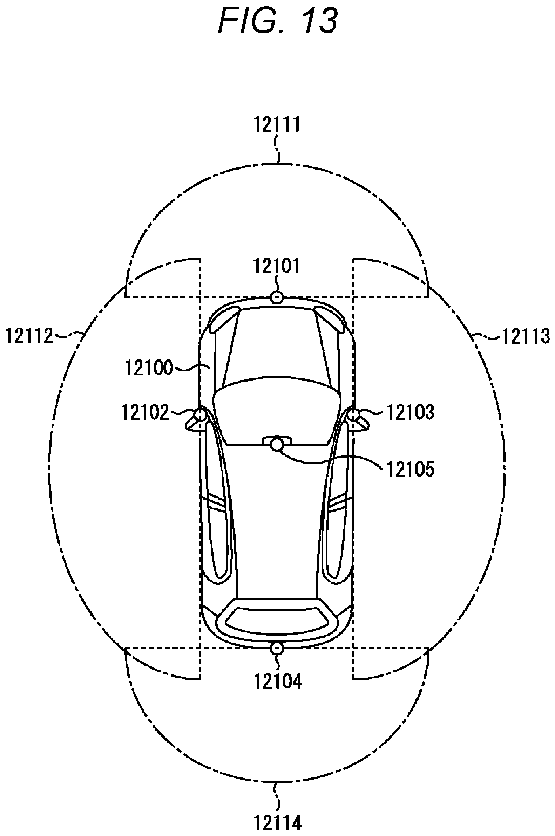

Fig. 13 is a diagram illustrating an example of installation positions of the imaging section 12031.

In Fig. 13, the imaging section 12031 includes imaging sections 12101, 12102, 12103, 12104, and 12105.

The imaging sections 12101, 12102, 12103, 12104, and 12105 are provided at positions, for example, the front nose, the sideview mirrors, the rear bumper, the back door, an upper portion of the windshield in the interior, and the like of the vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly images of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 13 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the above, an example has been described of the vehicle control system to which the technology according to the present disclosure can be applied. The technology according to the present disclosure can be applied to the imaging section 12031 among the components described above. Specifically, for example, the semiconductor devices 100 to 600 described above can be applied to the driving system control unit 12010, the body system control unit 12020, the outside-vehicle information detecting unit 12030, the in-vehicle information detecting unit 12040, and the integrated control unit 12050 of the vehicle control system 12000. Furthermore, the semiconductor device 700 described above can be applied to the imaging section 12031 of the vehicle control system 12000. By applying the technology according to the present disclosure to the vehicle control system 12000, it is possible to perform signal processing while suppressing influence of noise.

Note that the embodiments described above show examples for embodying the present technology, and the respective matters in the embodiments and the respective matters specifying the invention in the claims have correspondence relationships. Similarly, the respective matters specifying the invention in the claims and the respective matters with the same names in the embodiments of the present technology have correspondence relationships. However, the present technology is not limited to the embodiments, and can be embodied by making various modifications to the embodiments without departing from the scope of the present technology. Furthermore, effects described in the present specification are merely examples and are not limited, and other effects may be provided.

Note that the present technology may also have the following configuration.
(1) An electronic device including:
   a substrate;
   a through hole penetrating the substrate;
   a capacitive electrode formed along a side wall of the through hole and used for a capacitive element; and
   an electromagnetic shield layer formed along the side wall of the through hole and formed around the capacitive electrode.
(2) The electronic device according to (1), further including
   a wiring layer formed on the substrate.
(3) The electronic device according to (2), in which
   the capacitive electrode is formed from the side wall of the through hole to the wiring layer.
(4) The electronic device according to (2) or (3), in which
   the electromagnetic shield layer is not formed in the wiring layer.
(5) The electronic device according to any of (2) to (4), in which
   the electromagnetic shield layer is connected to a ground potential.
(6) The electronic device according to any of (2) to (5), in which
   the capacitive electrode includes:
   a first capacitive electrode used for the capacitive element;
   a second capacitive electrode used for the capacitive element; and
   a dielectric film provided between the first capacitive electrode and the second capacitive electrode.
(7) The electronic device according to any of (2) to (5), in which
   the electromagnetic shield layer is used as a capacitive electrode facing the capacitive electrode in the capacitive element.
(8) The electronic device according to any of (2) to (7), in which
   the through hole includes:
   a first through hole in which the capacitive electrode and the electromagnetic shield layer are formed; and
   a second through hole in which a through electrode is formed.
(9) The electronic device according to (8), in which
   the capacitive electrode is connected to the through electrode.
(10) The electronic device according to (8), in which
   the electromagnetic shield layer is connected to the through electrode.
(11) The electronic device according to any of (2) to (10), in which
   the capacitive electrode and the electromagnetic shield layer are formed across a plurality of through holes.
(12) The electronic device according to any of (2) to (11), in which
   the capacitive electrode is connected to a wiring line formed in the wiring layer.
(13) The electronic device according to any of (2) to (12), in which
   the capacitive electrode is connected to a guard ring formed in the wiring layer.
(14) The electronic device according to any of (2) to (13), further including
   a back surface wiring layer formed on a back surface side of the substrate.
(15) The electronic device according to (14), in which
   the capacitive electrode is connected externally via the back surface wiring layer.
(16) The electronic device according to (14) or (15), in which
   the electromagnetic shield layer is connected externally via the back surface wiring layer.
(17) The electronic device according to any of (14) to (16), in which
   a wiring line formed in the wiring layer and a back surface wiring line formed in the back surface wiring layer are connected to each other via the capacitive element.

### REFERENCE SIGNS LIST

100 Electronic device
101 Semiconductor substrate
102, 103 Through hole
104 Capacitive element
110 Wiring layer
111, 121 Insulating layer
112 Wiring line
113, 128 Via
120 Back surface wiring layer
122, 124, 126 Back surface wiring line
123, 125 Dielectric layer
127 Protective film
131 Through electrode
132 Electromagnetic shield layer
134, 136 Capacitive electrode
142, 144, 146 Opening

## Claims

1. An electronic device comprising:
a substrate;
a through hole penetrating the substrate;
a capacitive electrode formed along a side wall of the through hole and used for a capacitive element; and
an electromagnetic shield layer formed along the side wall of the through hole and formed around the capacitive electrode.

2. The electronic device according to claim 1, further comprising
a wiring layer formed on the substrate.

3. The electronic device according to claim 2, wherein
the capacitive electrode is formed from the side wall of the through hole to the wiring layer.

4. The electronic device according to claim 2, wherein
the electromagnetic shield layer is not formed in the wiring layer.

5. The electronic device according to claim 1, wherein
the electromagnetic shield layer is connected to a ground potential.

6. The electronic device according to claim 1, wherein
the capacitive electrode includes:
a first capacitive electrode used for the capacitive element;
a second capacitive electrode used for the capacitive element; and
a dielectric film provided between the first capacitive electrode and the second capacitive electrode.

7. The electronic device according to claim 1, wherein
the electromagnetic shield layer is used as a capacitive electrode facing the capacitive electrode in the capacitive element.

8. The electronic device according to claim 1, wherein
the through hole includes:
a first through hole in which the capacitive electrode and the electromagnetic shield layer are formed; and
a second through hole in which a through electrode is formed.

9. The electronic device according to claim 8, wherein
the capacitive electrode is connected to the through electrode.

10. The electronic device according to claim 8, wherein
the electromagnetic shield layer is connected to the through electrode.

11. The electronic device according to claim 1, wherein
the capacitive electrode and the electromagnetic shield layer are formed across a plurality of through holes.

12. The electronic device according to claim 2, wherein
the capacitive electrode is connected to a wiring line formed in the wiring layer.

13. The electronic device according to claim 2, wherein
the capacitive electrode is connected to a guard ring formed in the wiring layer.

14. The electronic device according to claim 2, further comprising
a back surface wiring layer formed on a back surface side of the substrate.

15. The electronic device according to claim 2, wherein
the capacitive electrode is connected externally via the back surface wiring layer.

16. The electronic device according to claim 2, wherein
the electromagnetic shield layer is connected externally via the back surface wiring layer.

17. The electronic device according to claim 2, wherein
a wiring line formed in the wiring layer and a back surface wiring line formed in the back surface wiring layer are connected to each other via the capacitive element.
